# EUROPEAN PATENT SPECIFICATION

(11) **EP 0 479 213 B1**
(45) Date of publication and mention of the grant of the patent: **01.05.1996**
(21) Application number: 91116707.0
(22) Date of filing: 30.09.1991
(51) Int. Cl.: H03G 7/00, H04N 5/202, G06G 7/28

(54) **Nonlinear processing method and apparatus**
Verfahren und Vorrichtung zur nichtlinearen Verarbeitung
Méthode et dispositif de traitement non-linéaire

(30) Priority: 02.10.1990 JP 263203/90
(43) Date of publication of application: 08.04.1992
(73) Proprietor: IKEGAMI TSUSHINKI CO., LTD., Ohta-ku Tokyo 146 (JP)
(72) Inventor: Hanajima, Hiroshi, Tokyo (JP)
(74) Representative: von Bülow, Tam, Dr.

(56) References cited:
- CH-A- 620 555
- US-A- 3 226 475
- US-A- 3 358 130
- ANNALES DE L'ASSOCIATION INTERNATIONALE POUR LE CALCUL ANALOGIQUE, vol. 13, no. 4, October 1971, pages 156-159, Bruxelles, BE; G. RODRIGUEZ-IZQUIERDO et al.: "High gain integrated amplifiers stabilize function generators"
- ANALOG DEVICES: "Data acquisition products catalog", 1978, pages 7-20: "Operational amplifiers", Analog Devices, Inc., Norwood, US
- PATENT ABSTRACTS OF JAPAN, vol. 8, no. 135 (E-252)[1572], 22nd June 1984; & JP-A-59 45 775 (SHARP K.K.) 14-03-1984

## Description

### (1) Field of the Invention

The present invention relates to a method and an apparatus for performing nonlinear processing, such as gamma compensation of a color camera apparatus.

### (2) Description of the Related Art

In a color television apparatus, the level of an input frequency and the level of output light- emission of a cathode ray tube have a nonlinear relationship (gamma characteristic of the cathode ray tube). Therefore, a so-called gamma compensation or reverse-compensation for the gamma characteristic of the cathode ray tube is performed on the camera side, thereby providing an easy-to-see image.

The gamma compensation is carried out by changing the gain of an amplifier in accordance with the level of the input signal.

There is a conventional basic gamma compensator which acquires the input/output characteristic as an approximation of an inclination-changing line.

The conventional gamma compensator however has the following shortcomings.

First, the frequency responses for the operating portions corresponding to individual line segments which constitute the input/output characteristic cannot be determined independently. For instance, if one tries to perform adjustment to provide the best frequency response in a black level region where the signal lever is low, the adjustment will affect the frequency response in a region where the signal level is high. Therefore this necessitates setting the frequency response in light of a balance over the whole level range, making it difficult to provide the optimal frequency response for each level range.

Secondary, it is necessary to take a wide dynamic range because an approximation is acquired by adding signals.

The publication "ANNALES DE L'ASSOCIATION INTERNATIONALE POUR LE CALCUL ANALOGIQUE", vol. 13, no. 4, October 1971, pages 156-159 describes function generators comprising multiple amplifiers connected in such a way as to have input terminals supplied with a common input signal and a circuit of diodes, each diode being connected to the output of a respective one of the multiple amplifiers, said circuit of diodes is independently receiving outputs of the multiple amplifiers and selectively outputting the output of one of the amplifiers being selected for each level region of the input signal. Each amplifier has a different amplification factor and different offset voltages. In this function generator only one amplifier output signal is output by the diode selecting circuit and the switching to another amplifier is done, when both amplifier output signal levels become equal to each other. In one embodiment of this publication the diode selecting circuit selects the amplifier with the lowest absolute output signal level. With this known function generator it is possible to approximate desired functions by linear segments. For each segment of the desired function an individual amplifier is needed.

### Summary of the Invention

It is therefore a primary object of the present invention to provide a method and an apparatus having a reduction in the number of amplifiers required.

It is a further object of the present invention to provide a method and apparatus which can overcome the above conventional problems and can allow for easy and highly-accurate setting and adjustment to the desired nonlinear output characteristic.

It is another object of the present invention to permit the dynamic range of each constituent circuit to approach a usable range which is input output level as much as possible, thereby improving the durability and reliability and reducing the costs of parts, which results in reduction in the manufacturing cost.

It is a further object of the present invention to allow for easy readjustment of a characteristic with respect to a change in the characteristic with passage of time even after the individual constituent circuits are assembled.

To achieve the above objects, according to one aspect of the present invention, there is provided a nonlinear processing apparatus comprising multiple amplifiers having mutually different amplification factors and different offset voltages and connected in such a way as to have input terminals supplied with a common input signal; at least two independent voltage dividers connected to the outpout terminal of each amplifier and having different voltage-divided outputs, each each voltage divider being predetermined to have its output signal selected for a certain level region of the input signal; and a non-additive mixing circuit for independently receiving the voltage-divided outputs of the voltage dividers and selectively outputting the voltage-divided output of each of the voltage dividers selected for the present level region of the input signal.

With the above structure, the non-additive mixing circuit switches the independently-received signal outputs of the voltage dividers for each input signal level and outputs the selected one, thereby providing a total output signal totalizing each selected output, having the nonlinear characteristic.

The input/output characteristics of individual amplifiers can be independently set and adjusted without being affected by the input/output characteristics of the other amplifiers. This feature can enhance the freedom of setting and adjusting the final output characteristics.

In addition, the amplifiers take their share of only part of the final output level range. With regard to the dynamic range of each amplifier, therefore, it is sufficient to secure the one corresponding to the share. Even for that amplifier which requires the maximum dynamic range, the dynamic range substantially the same as that of the final output is sufficient and each amplifier has only to hold a good output characteristic only in the output level region to be used, thus ensuring a good characteristic over the entire output level range.

The non-additive mixing circuit may be designed to switch outputs of two amplifiers from one to the other at the point where output signal levels of the two amplifiers become equal to each other with respect tot an input signal level.

This can provide a nonlinear input/output characteristic which is an approximation of a continuous inclination-changing line.

Further, the smaller the amplification factors of the multiple amplifiers, the larger offset voltages the multiple amplifiers have, and the non-adder/mixer selectively outputs the output of that amplifier whose absolute value becomes minimum.

This structure provides a nonlinear output characteristic which shows the inclination of a continuous inclination-changing line becoming smaller in accordance with an approximation of a continuous inclination-changing line and an increase in the input signal level.

Each amplifier may be provided with an output characteristic regulator.

With this structure, the characteristic of each amplifier can be adjusted without any influence from the other amplifiers even with passage of time after as well as before incorporating the amplifiers.

With the above structure of claim 1, although the output characteristics for those voltage dividers connected to the same amplifier cannot be adjusted independently, the output characteristics for those voltage dividers connected to different amplifiers can be adjusted independently so that the number of the amplifiers in use can be reduced, thus resulting in reduction of the manufacturing cost.

Further, this nonlinear processing apparatus may be applied to a gamma compensator, thus facilitating the setting and adjustment of the gamma characteristic.

When the nonlinear processing apparatus is applied to a gamma compensator, each amplifier may be provided with a frequency response regulator. In this case, independent adjustment of the frequency response is possible in accordance with the frequency range of the input signal corresponding to the output region selected for each amplifier by the non-adder/mixer.

In the case of the nonlinear processing apparatus being applied to a gamma compensator, each amplifier may be provided with an offset frequency regulator. Accordingly, the offset voltages can be adjusted independently of adjustment of the frequency response as well as for the respective amplifiers.

With the use of the offset voltage regulator, the regulator is usually set the offset voltage, which is the output voltage of the amplifier, corresponding to a part of the minimum value of the input signal level to zero.

According to a further aspect of the present invention, there is provided a nonlinear processing method comprising the steps of independently generating a plurality of output signals having different offset voltages from amplifiers having different amplification factors with respect to a common input signal; voltage dividing each of the plurality of output signals independently by at least two independent voltage dividers connected to the output terminal of each amplifier to provide a plurality of different voltage divided signals, each of which is predetermined to be selected for a certain level region of the input signal; and independently receiving the voltage-divided outputs of the voltage dividers and selectively outputting the voltage-divided output of each of the voltage dividers selected for the present level region of the input signal.

This method can provide an arbitrary nonlinear output characteristic and can permit independent adjustment of the output characteristic for each selected output signal.

### Brief Description of the Drawings

Fig. 1 is a circuit diagram illustrating a non-linear processing apparatus;
Fig. 2 is a characteristic diagram which illustrates the characteristics of Fig. 1;
Fig. 3 is a circuit diagram illustrating the structure of a partial modification of Fig. 1;
Fig. 4 is circuit diagram illustrating the structure of an embodiment of the present invention;
Fig. 5 is an equivalent circuit diagram for explaining the computation of voltage values of individual sections in the embodiment of the invention;
Fig. 6 is a circuit diagram exemplifying section of frequency response regulator and an offset voltage regulator in the embodiment of the invention;
Fig. 7 is a circuit diagram showing another example of the section including the frequency response regulator and offset voltage regulator;
Fig. 8 is a circuit diagram of first prior art;
Fig. 9 is a characteristic diagram of the prior art;
Fig. 10 is a circuit diagram of second prior art; and
Fig. 11 is a characteristic diagram of the second prior art.

### Detailed Description of The Preferred Embodiments

Preferred embodiments of the present invention will now be described referring to the accompanying drawings.

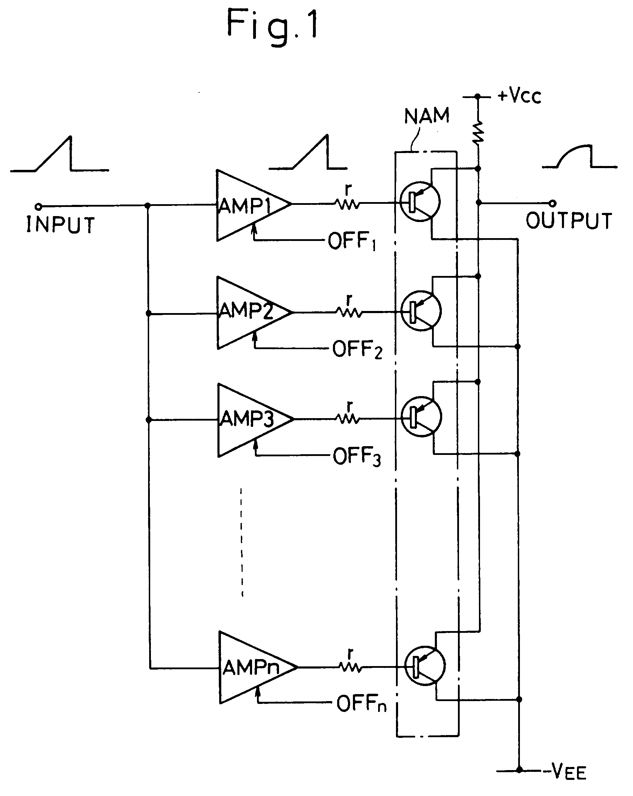

Fig. 1 illustrates a non-linear processing circuit used as a gamma compensator.

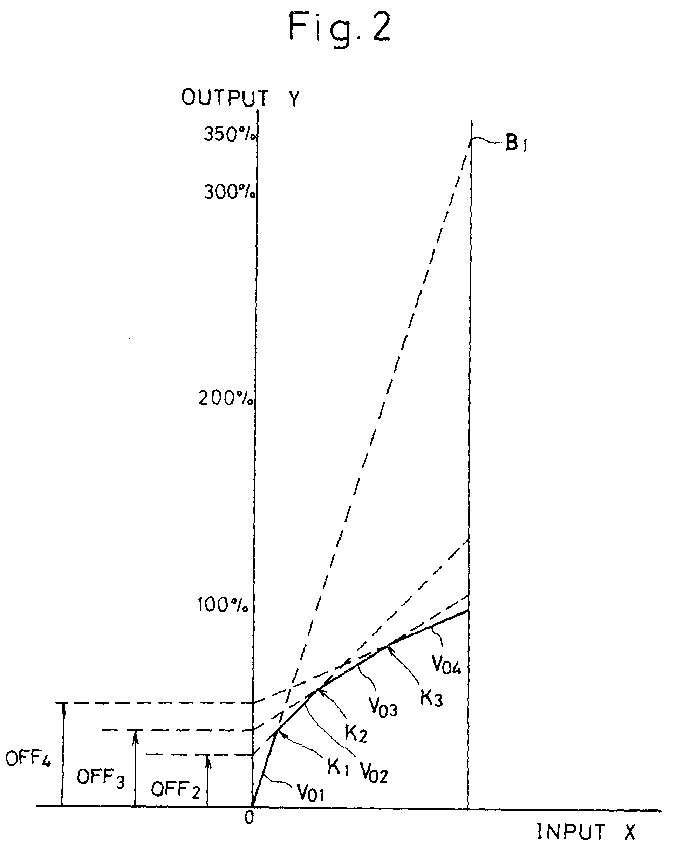

Referring to the diagram, the gamma compensator hat its input terminal I connected with the input terminals of n amplifiers AMP1 to AMPn. The gains A₁ to Aₙ of these amplifiers AMP1 - AMPn are so set to become smaller in order while their offset voltages OFF₁ to OFFₙ are so set to become larger in order. OFF1 as the set value of the offset voltage regulator is set to a value so that the output of the amplifier AMP1 equals to the reference potential, w.e. zero when the input level of the gamma compensator is zero. A collector earthed circuit in which each emitter of a plurality of transistors is connected with a line serves as a non-additive mixing circuit in the following called a non-adder/mixer NAM. The output of the non-adder/mixer NAM corresponds to a voltage obtained by adding the voltage between the base and the emitter in NAM added to the output voltage of each amplifier. Accordingly, the obtained voltage equals to the output voltage of the nonlinear processing circuit.. The gains A₁ -Aₙ and offset voltages OFF₁-OFFₙ of the individual amplifiers AMP1 to AMPn are set in such a manner that, as shown in Fig. 2, changing points K₁ to Kₙ-1 of the inclination-changing line characteristic (indicated by the solid line) acquired by connecting lowest ones of output voltages V₀₁ to V_{0n,} which change in accordance with the input signal frequency Vᵢ of the individual amplifiers AMP1-AMPn, lie on the desired gamma curve. (The inclination-changing line characteristic sill by simply referred to as "line characteristic" hereinafter.)

The amplifiers AMP1-AMPn each have an output terminal connected via a resistor r to an associated one of the input terminals of a non-adder/mixer NAM. The non-adder/ mixer NAM has the potential of its output terminal ○ or its output voltage determined by that transistor which receives the lowest one of input voltages applied to the individual input erminals of the non-adder/mixer NAM, so that the non-adder/mixer NAM always selects the minimum voltage as its output voltage.

Referring now to Fig. 2, the action of Fig. 1 will be described.

When an image signal voltage Vᵢ of a positive polarity is input to the individual amplifiers AMP1 - AMPₙ from the input terminal | of the gamma compensator, these amplifiers output the output voltages V₀₁-V₀ₙ according to the aforementioned, respective characteristics.

When the output voltages V₀₁-V₀₂ are input to the non-adder/mixer NAM, the non-adder/mixer NAM outputs the output voltage corresponding to the lowest one of the output voltages V₀₁-V₀ₙ due to the aforementioned function.

Accordingly, the input/output characteristic of the non-adder/mixer NAM becomes the line characteristic of the gamma chracteristic as indicated by the solid line in Fig. 2.

With the above structure, the output characteristic of each of the amplifiers AMP1-AMPn can be set for the desired characteristic without being influenced by the characteristics of the other amplifiers, so that the voltage response of each amplifier can be set independently without being affected by the characteristics of the other amplifiers. In tis manner, the voltage response within each line segment can be set optimally in accordance with the output level. Generally, the voltage response for a black level is particularly important in processing signals in a video system. The frequency response only for the black level can be adjusted alone to the optimal one according to this embodiment by setting the frequency response of the amplifier AMP1. The frequency response for another level among the intermediate level to the white level can be set optimally by setting the frequency response of that of the amplifiers AMP2-AMPn which is associated with that level. It is to be noted that the specific frequency response and offset voltage are set by a frequency response regulator and an offset voltage regulator (both to be described later), which are provided for each amplifier.

The dynamic range of this circuit is determined by the dynamic range of the signal V₀ₙ of the amplifier AMPn (n = 4 in Fig. 2). For instance, if the signals V₀₁-V₀₃ are clipped and distorted around the point of 110% due to the power supply voltage or the like, no distortion would appear on the output of the present circuit. This is because the non-adder/mixer NAM switches between the outputs so that no distorted portion appears on the final output.

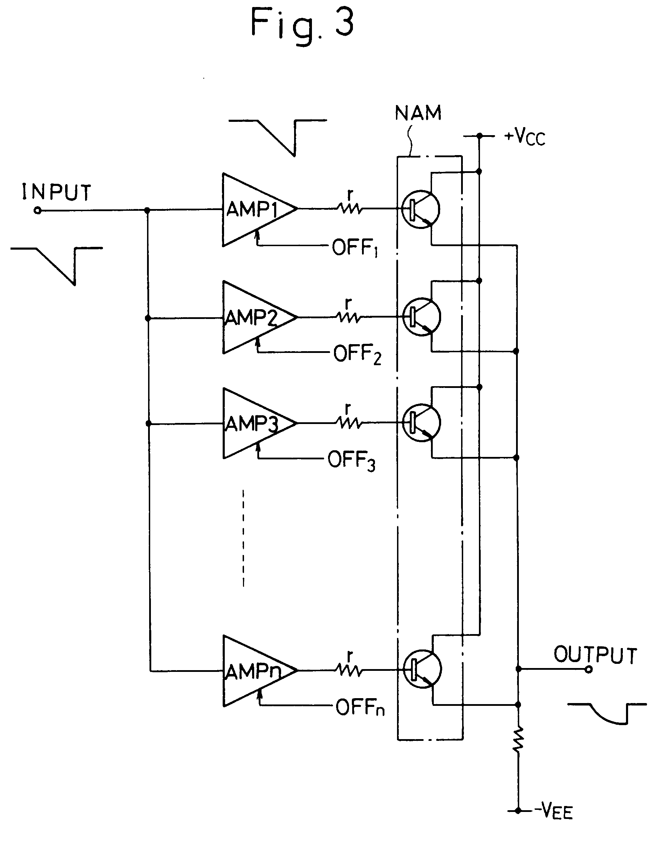

Fig. 3 illustrates a modification of the above circuit. In this modification, a polarity of input and output signals is changed from positive to negative. Therefore, the non-adder/mixer NAM is modified from a PNP type to a NPN type. Further, contrary to the circuit in Fig. 1, the offset voltage of each amplifier becomes OFF1 > OFF2 > .....> OFFn by comparison with d.c.potential. However, if the output reference level is referenced, the offset voltage is |OFF1| < |OFF2| <.....< |OFFn| and consequently, the basic difference is not found out except for a difference in polarity. Accordingly, of outputs of negative polarity of the amplifiers AMP1-AMPn, the one whose absolute value is the smallest is to be selected and then output. The structure of the other portions is the same as that of the first embodiment.

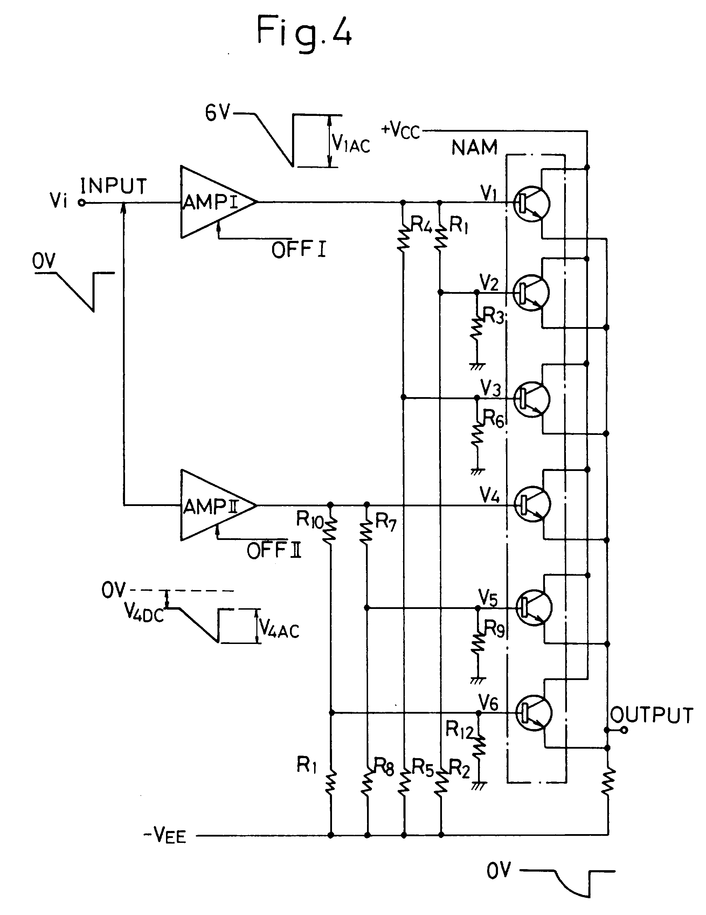

Fig. 4 illustrates an embodiment of the invention of a simple type in which the number of amplifiers in use is reduced smaller than the number of segments of the inclination-changing line.

Referring to this diagram, an amplifier AMPI and resistors R₁ to R₆ connected thereto are used to acquire three line output characteristics V₁ to V₃ from the minimum level to the intermediate level, while an amplifier AMPII and resistors R₇ to R₁₂ connected thereto are used to acquire three line output characteristics V₄ to V₆ from the intermediate level to the maximum level. It is to be noted that the input signal Vᵢ and outputs V₁ to V₆ have a negative polarity, so that these outputs V₁ -V₆ are input to the respective input terminals of a non-adder/mixer NAM having the same structure as the one shown in Fig. 3.

In Fig. 4, let the DC potentials of V₁ to V₆ be V_{1DC} to V_{6DC}, and let the AC components of the signal voltage be V_{1AC} to V_{6AC}, where the set value OFFI of the offset voltage regulator is set so that the offset voltage V1DC corresponds to zero volt which is the same potential as the output reference potential. V4DC is the offset voltage of the amplifier AMPII, and the set value OFFII of offset voltage re regulator is set so that the offset voltage V4DC corresponds to a predetermined value. V_{1AC} is determined by the gain A₁ of the amplifier AMPI (V_{1AC} = A₁·Vᵢ), and V_{4AC} is determined by the gain A₁₁ of the amplifier AMPII(V_{4AC} = A₁₁·Vᵢ)

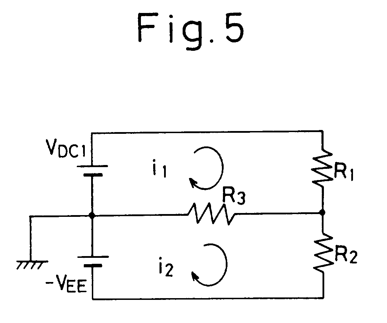

At this time, V_{2DC}-V_{6DC} are acquired by performing calculation to be described later. First, V_{2DC} will be acquired in the following manner. Let i₁ and i₂ be the individual loop currents in an equivalent circuit shown in Fig. 5.

Then,${\text{V}}_{\text{1DC}} {\text{= R}}_{\text{i}} {\text{1}}_{\text{1}} {\text{+ R}}_{\text{3}} {\text{i}}_{\text{1}} {\text{- R}}_{\text{3}} {\text{i}}_{\text{2}}$${\text{V}}_{\text{EE}} {\text{= R}}_{\text{3}} {\text{i}}_{\text{1}} {\text{+ R}}_{\text{2}} {\text{i}}_{\text{2}} {\text{+ R}}_{\text{3}} {\text{i}}_{\text{2}}$

Solving the above for i₁ and i₂ yields${\text{i}}_{\text{1}} \text{=} \frac{{\text{(R}}_{\text{2}} {\text{+ R}}_{\text{3}} {\text{)V}}_{\text{1DC}} {\text{+ R}}_{\text{3}} {\text{V}}_{\text{EE}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$${\text{i}}_{\text{2}} \text{=} \frac{{\text{(R}}_{\text{3}} {\text{+ R}}_{\text{1}} {\text{)V}}_{\text{EE}} {\text{+ R}}_{\text{3}} {\text{V}}_{\text{1DC}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$

Since V_{2DC} is a voltage across R₃,${\text{V}}_{\text{2DC}} {\text{= R}}_{\text{3}} {\text{(i}}_{\text{1}} {\text{- i}}_{\text{2}} \text{)} {\text{= R}}_{\text{3}} {\text{{(R}}_{\text{2}} {\text{+ R}}_{\text{3}} {\text{)V}}_{\text{1DC}} {\text{+ R}}_{\text{3}} {\text{V}}_{\text{EE}} {\text{- (R}}_{\text{3}} {\text{+ R}}_{\text{1}} {\text{)V}}_{\text{EE}} {\text{- R}}_{\text{3}} {\text{V}}_{\text{1}} {\text{}/(R}}_{\text{1}} {\text{R}}_{\text{2}} {\text{+ R}}_{\text{2}} {\text{R}}_{\text{3}} {\text{+ R}}_{\text{3}} {\text{R}}_{\text{1}} \text{)} {\text{= R}}_{\text{3}} \frac{{\text{R}}_{\text{2}} {\text{V}}_{\text{1DC}} {\text{- R}}_{\text{1}} {\text{V}}_{\text{EE}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$

Likewise,${\text{V}}_{\text{3DC}} {\text{= R}}_{\text{6}} \frac{{\text{R}}_{\text{5}} {\text{V}}_{\text{1DC}} {\text{- R}}_{\text{4}} {\text{V}}_{\text{EE}}}{{\text{R}}_{\text{4}} {\text{R}}_{\text{5}} {\text{+ R}}_{\text{5}} {\text{R}}_{\text{6}} {\text{+ R}}_{\text{6}} {\text{R}}_{\text{4}}}$${\text{V}}_{\text{5DC}} {\text{= R}}_{\text{9}} \frac{{\text{R}}_{\text{8}} {\text{V}}_{\text{4DC}} {\text{- R}}_{\text{7}} {\text{V}}_{\text{EE}}}{{\text{R}}_{\text{7}} {\text{R}}_{\text{8}} {\text{+ R}}_{\text{8}} {\text{R}}_{\text{9}} {\text{+ R}}_{\text{9}} {\text{R}}_{\text{7}}}$${\text{V}}_{\text{6DC}} {\text{= R}}_{\text{12}} \frac{{\text{R}}_{\text{11}} {\text{V}}_{\text{4DC}} {\text{- R}}_{\text{10}} {\text{V}}_{\text{EE}}}{{\text{R}}_{\text{10}} {\text{R}}_{\text{11}} {\text{+ R}}_{\text{11}} {\text{R}}_{\text{12}} {\text{+ R}}_{\text{12}} {\text{R}}_{\text{10}}}$

Since V_{1DC} = 0,${\text{V}}_{\text{2DC}} \text{=} \frac{{\text{-R}}_{\text{3}} {\text{R}}_{\text{1}} {\text{V}}_{\text{EE}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$${\text{V}}_{\text{3DC}} \text{=} \frac{{\text{-R}}_{\text{6}} {\text{R}}_{\text{4}} {\text{V}}_{\text{EE}}}{{\text{R}}_{\text{4}} {\text{R}}_{\text{5}} {\text{+ R}}_{\text{5}} {\text{R}}_{\text{6}} {\text{+ R}}_{\text{6}} {\text{R}}_{\text{4}}}$

V1AC to V6AC are acquired through a similar computation. The results are as follows:${\text{V}}_{\text{1DC}} \text{= 0}$${\text{V}}_{\text{2DC}} \text{=} \frac{{\text{-R}}_{\text{3}} {\text{R}}_{\text{1}} {\text{V}}_{\text{EE}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$${\text{V}}_{\text{3DC}} \text{=} \frac{{\text{-R}}_{\text{6}} {\text{R}}_{\text{4}} {\text{V}}_{\text{EE}}}{{\text{R}}_{\text{4}} {\text{R}}_{\text{5}} {\text{+ R}}_{\text{5}} {\text{R}}_{\text{6}} {\text{+ R}}_{\text{6}} {\text{R}}_{\text{4}}}$$\text{V4DC = V4DC}$${\text{v}}_{\text{5DC}} {\text{= R}}_{\text{9}} \frac{{\text{R}}_{\text{8}} {\text{V}}_{\text{4DC}} {\text{- R}}_{\text{7}} {\text{V}}_{\text{EE}}}{{\text{R}}_{\text{7}} {\text{R}}_{\text{8}} {\text{+ R}}_{\text{8}} {\text{R}}_{\text{9}} {\text{+ R}}_{\text{9}} {\text{R}}_{\text{7}}}$${\text{V}}_{\text{6DC}} {\text{= R}}_{\text{12}} \frac{{\text{R}}_{\text{11}} {\text{V}}_{\text{4DC}} {\text{- R}}_{\text{10}} {\text{V}}_{\text{EE}}}{{\text{R}}_{\text{10}} {\text{R}}_{\text{11}} {\text{+ R}}_{\text{11}} {\text{R}}_{\text{12}} {\text{+ R}}_{\text{12}} {\text{R}}_{\text{10}}}$$\text{V1AC = A1Vi}$${\text{V}}_{\text{2AC}} \text{=} \frac{{\text{R}}_{\text{2}} {\text{R}}_{\text{3}} {\text{V}}_{\text{1AC}}}{{\text{R}}_{\text{1}} {\text{R}}_{\text{2}} {\text{+ R}}_{\text{2}} {\text{R}}_{\text{3}} {\text{+ R}}_{\text{3}} {\text{R}}_{\text{1}}}$${\text{V}}_{\text{3AC}} \text{=} \frac{{\text{R}}_{\text{5}} {\text{R}}_{\text{6}} {\text{V}}_{\text{1AC}}}{{\text{R}}_{\text{4}} {\text{R}}_{\text{5}} {\text{+ R}}_{\text{5}} {\text{R}}_{\text{6}} {\text{+ R}}_{\text{6}} {\text{R}}_{\text{4}}}$${\text{V}}_{\text{4AC}} {\text{= A}}_{\text{11}} {\text{V}}_{\text{i}}$${\text{V}}_{\text{5AC}} \text{=} \frac{{\text{R}}_{\text{8}} {\text{R}}_{\text{9}} {\text{V}}_{\text{4AC}}}{{\text{R}}_{\text{7}} {\text{R}}_{\text{8}} {\text{+ R}}_{\text{8}} {\text{R}}_{\text{9}} {\text{+ R}}_{\text{9}} {\text{R}}_{\text{7}}}$${\text{V}}_{\text{6AC}} \text{=} \frac{{\text{R}}_{\text{11}} {\text{R}}_{\text{12}} {\text{V}}_{\text{4AC}}}{{\text{R}}_{\text{10}} {\text{R}}_{\text{11}} {\text{+ R}}_{\text{11}} {\text{R}}_{\text{12}} {\text{+ R}}_{\text{12}} {\text{R}}_{\text{10}}}$

Then, the values of R1 to R12 are determined so that V_{1DC} > V_{2DC} > V_{3DC} > V_{4DC} > V_{5DC} > V_{6DC}, and V_{1AC} > V_{2AC} > V_{3AC} > V_{4AC}> V_{5AC} > V_{6AC}.

By setting arbitrary values in this manner, approximation by an arbitrary inclination-changing line for non liner curve is possible.

As the characteristics of the amplifiers AMPI and AMPII can be independently set in this case, the frequency responses for the levels from the minimum level to the intermediate level, V₁, V₂ and V₃, and the frequency responses for the levels from the intermediate level to the maximum level, V₄,V₅ and V₆, can be independently set. This results in reduction in the manufacturing cost by the number of amplifiers reduced. Since the frequency responses between V₁, V₂ and V₃ and those between V₄, V₅ and V₆ cannot independently be set, they have only to be selected in light of the cost and the required performance. The amplifiers may be increased in the apparatus of this embodiment type. For instance, a modification may be made so that for a total of six line characteristics, three amplifiers each can deal with two for the associated level, small, intermediate or large, or the number of amplifiers may be increased for a level region where the demand for the frequency response is high (generally, around the black level for a video image) to preponderantly cope with this region.

Even in this case, since the non-adder/mixer NAM selectively outputs the output whose absolute value is minimum, the dynamic range can be narrowed.

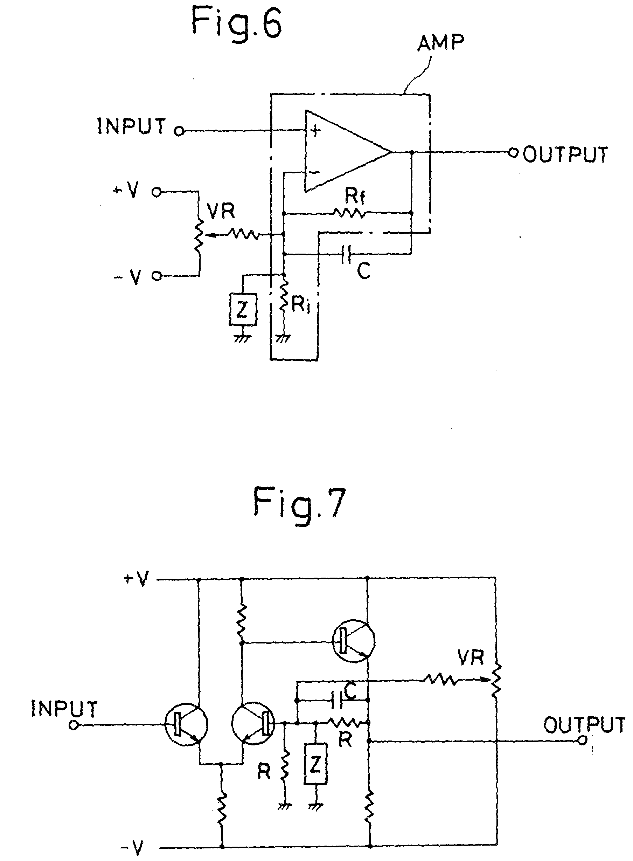

A description will now be given of specific examples of the frequency response regulator and offset voltage regulator which are provided for each amplifier in the above-described embodiments. Fig. 6 illustrates an amplifier portion provided with such regulators. Although only one amplifier portion is shown in the diagram, the frequency response regulator and offset voltage regulator are actually provided, as mentioned above, for each amplifier in the individual embodiments discussed above.

Referring to Fig. 6, an amplifier element and resistors Rᵢ and R_{f} located within the one-dot chain line constitute an amplifier AMP (a simplified illustration has been given in the foregoing description of each embodiment). As the frequency response regulator, and impedance adjusting element Z (constituted by, for example, a capacitor, a series circuit of a capacitor and a resistor or the like) may be connected between the negative (-) input terminal of the amplifier AMP and the ground, or capacitor C may be connected between the negative (-) input terminal and output terminal of the amplifier AMP. The impedance adjusting element Z and capacitor C may both be connected to the amplifier AMP as needed. It is to be noted that the impedance adjusting element Z serves mainly to increase the high-frequency level in a desired region, while the capacitor C serves to lower the frequency level over the entire output level range.

As the offset voltage regulator, a variable resistor VR is coupled to the negative input terminal of the amplifier AMP.

Fig. 7 illustrates an embodiment in which an amplifier comprises multiple transistors and multiple resistors. In this embodiment also, at least one of the impedance adjusting element Z or the capacitor C is coupled as needed to the illustrated location, and the variable resistor VR is coupled to a predetermined location as the offset voltage regulator.

The offset voltage regulator is freely adjustable by manipulating the variable resistor VR, and the frequency response regulator can also be adjusted even after the constituent elements are assembled if the impedance adjusting element Z and/or capacitor C is designed adjustable. In this case, needless to say, adjustment can be performed independently amplifier by amplifier and will not affect the other amplifiers.

If no adjustment is to be carried out after the constituent elements are assembled (normally, such is sufficient), the variable resistor VR may be changed to a fixed resistor.

What have been explained in the foregoing description are simply examples of the circuits to adjust the frequency response and offset voltage. It is well known that there are other numerous examples of such a circuit which can provide the same effects.

Further, the present invention is not limited to a gamma compensator as illustrated in the foregoing description of the individual embodiments, but may be applied to other circuits which execute nonlinear processing (mainly, image signal processing) as well.

### Comparison Between Present Invention and Prior Art

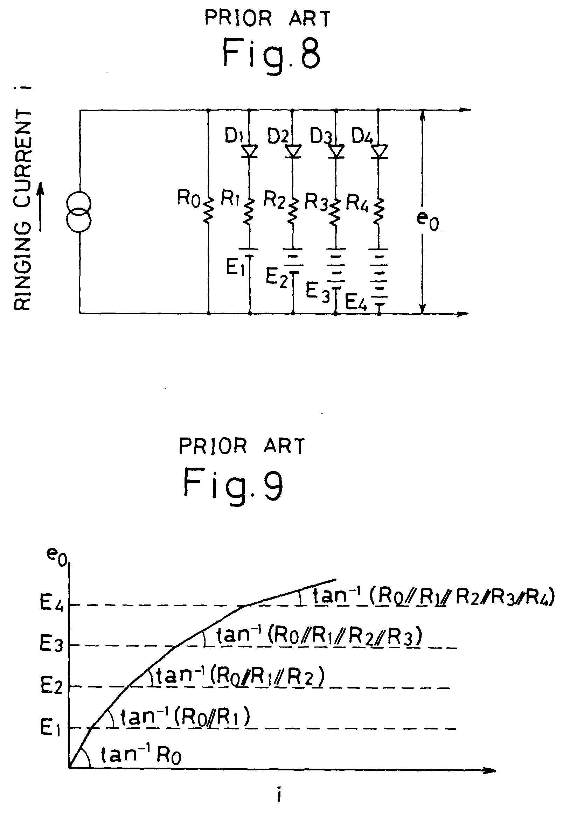

One conventional, fundamental gamma compensator is illustrated in Fig. 8; the gamma compensation characteristic of this circuit can be acquired by approximation of an inclination-changing line.

In Fig. 8 "i" denotes a signal current, "E₁", "E₂", "E₃", and "E₄" denote power supply voltage, "R₀", "R₁", "R₃" and "R₄" are resistors, and "D₁", "D₂", "D₃" and "D₄" are diodes.

In Fig. 9 presenting the line characteristic, "E₁", "E₂", "E₃", and "E₄" are voltages at points where the line inclination is changed,
tan⁻¹R₀, Tan⁻¹ (R₀//R₁ ), tan⁻¹( R₀//R₁//R₂ ), tan⁻¹ ( R₀//R₁//R₂//R₃ ), and
tan⁻¹ ( R₀//R₁//R₂//R₃//R₄)
are inclinations of the respective line segments where the symbol "//" represents a parallel resistance of the resistors.

After the bending-point voltages E₁, E₂, E₃, and E₄ the diodes D₁, D₂, D₃ and D₄ are sequentially rendered conductive and the resistors R₁, R₂, R₃ and R₄ are sequentially added. With the current source of this circuit considered in terms of the voltage source, the necessary dynamic range is i·R₀.

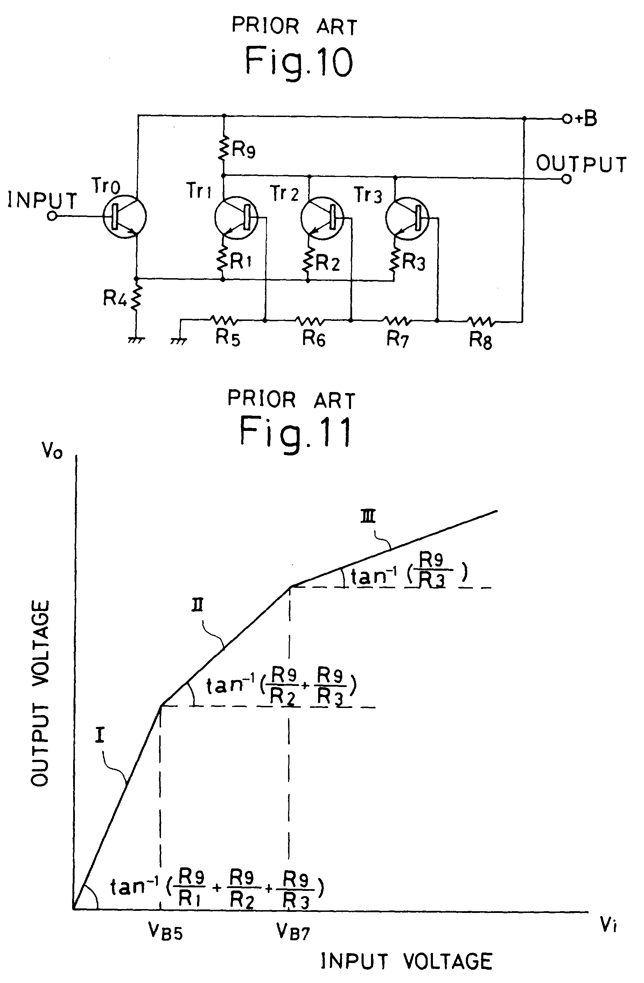

Fig. 10 illustrates another example of the gamma compensator employing the approximation of an inclination-changing line (refer to Published Examined Japanese Patent Application No. JP-A-59-45 775.

In this circuit, when the input signal voltage Vi rises, amplifiers Tr₁, Tr₂, and Tr₃ are sequentially cut off and consequently stop to add the each output sequentially (see Fig. 11).

The Following will discuss the problems of these conventional gamma compensators.

According to a fist technique of the prior art as shown in Figs. 8 and 9, at first the frequency responses for the individual line segments cannot independently be determined as is apparent from the above formula of the line inclination. For instance, if one tries to perform adjustment to provide the best frequency response in a black level region where the signal level is low, the adjustment will affect the frequency response in a region where the signal level is high. It is therefore necessary to set the frequency response in light of a balance over the whole level range, so that the optimal frequency response for each level cannot be acquired.

Secondary, it is necessary to take a wide dynamic range because an approximation is acquired by adding signals. Let us consider a case where, referring to Fig. 2, a point (X, Y) on the graph of Y = X⁰˙⁴⁵ is approximated so as to change at (0.1, 0.35), (0.3, 0.58), (0.6, 0.79) and (0.8, 0.9) in order to provide an approximation to a characteristic of γ = 0.45 or Y = ⁰˙⁴⁵.

In this case, in order to obtain a signal with a 100% output level, the input level a signal source which may output B1(350%) is needed. This is because and approximated straight line of (X,Y) connection (0,0) and (0.1, 0.35) yields Y = 3.50 when the inclination is tan⁻¹R₀ and X = 1. In other words, the dynamic range required is i·R0 - 350%.

If the input signal is distorted at a level equal to or below B₁, a distorted signal will be output because approximation is executed by adding signals.

Even in a second technique of the prior art shown in Fig. 10, since the outputs of Tr₁, Tr₂ and Tr₃ are added, the frequency responses in the individual level ranges cannot independently be adjusted as per the first prior art.

Like the first prior art, the second prior art takes an approximation of the gamma curve by adding signals, so that if one of the signals to be added is distorted due to clipping or the like, a distorted signal would be output.

For instance, if the inclination of the ⁻ ¹R₀ shown in Fig. 9 equals the inclination of tan⁻¹(R₉/R₁ + R₉/R₂ + R₉/R₃) shown in Fig. 11 the dynamic range of 350% is necessary to acquire a signal with a 100% output level in the case illustrated in Fig. 11 as in the case of Fig. 9.

In contrast, according to the present invention, since the characteristics of the individual line segments can be obtained by selectively switching and outputting the outputs of the individual amplifiers from one to another (unlike the prior art wherein the individual outputs of the amplifiers are added to be a final output), the characteristics of the individual line segments can independently be set or adjusted and the dynamic range can be designed narrower even though the circuit is designed as having a same output level.

## Claims

1. A nonlinear processing apparatus comprising:
multiple amplifiers (AMP I, AMP II) having mutually different amplification factors and different offset voltages (OFF I, OFF II) and connected in such a way as to have input terminals supplied with a common input signal (Vi);
at least two independent voltage dividers (R₁, R₂; R₄, R₅; R₇, R₈; R₁₀, R₁₁) connected to the output terminal of each amplifier and having different voltage-divided outputs, each voltage divider being predetermined to have its output signal selected for a certain level region of the input signal; and
a non-additive mixing circuit (NAM) for independently receiving the voltage-divided outputs of the voltage dividers (R₁, R₂; R₄, R₅; R₇, R₈; R₁₀, R₁₁) and selectively outputting the voltage-divided output of the voltage divider selected for the present level region of the input signal (Vi).

2. A nonlinear processing apparatus according to Claim 1, wherein the nonlinear processing apparatus is used as a gamma compensator.

3. A nonlinear processing apparatus according to Claim 2, wherein each of the amplifiers (AMP I; AMP II) is provided with a frequency response regulator (AMP, Z).

4. A nonlinear processing apparatus according to Claim 2, wherein each of the amplifiers (AMP I, AMP II) is provided with an offset voltage regulator (AMP, VR).

5. A nonlinear processing apparatus according to Claim 4, wherein an offset voltage corresponding to a minimum value of an input signal level is set to zero.

6. A nonlinear processing method comprising the steps of:
independently generating a plurality of output signals having different offset voltages from amplifiers having different amplification factors with respect to a common input signal;
voltage dividing each of the plurality of output signals independently by at least two independent voltage dividers connected to the output terminal of each amplifier to provide a plurality of different voltage divided signals, each of which is predetermined to be selected for a certain level region of the input signal; and
independently receiving the voltage-divided outputs of the voltage dividers and selectively outputting the voltage-divided output of each of the voltage dividers selected for the present level region of the input signal.

## Patentansprüche

1. Vorrichtung zur nichtlinearen Verarbeitung, mit:
mehreren Verstärkern (AMP I, AMP II) mit zueinander unterschiedlichen Verstärkungsfaktoren und unterschiedlichen Offsetspannungen (OFF I, OFF II), die derart miteinander verbunden sind, daß ihre Eingangsanschlüsse von einem gemeinsamen Eingangssignal (Vi) gespeist werden;
mindestens zwei unabhängigen Spannungsteilern (R₁, R₂; R₄, R₅; R₇, R₈; R₁₀, R₁₁), die mit den Ausgangsanschlüssen jedes Verstärkers verbunden sind und verschiedene spannungsgeteilte Ausgangssignale haben, wobei jeder Spannungsteiler vorbestimmt ist, ein für einen bestimmten Pegelbereich des Eingangssignals gewähltes Ausgangssignal zu haben; und
einem nicht-additiven Mischkreis (NAM) zum voneinander unabhängigen Empfang der spannungsgeteilten Ausgangssignale der Spannungsteiler (R₁, R₂; R₄, R₅; R₇, R₈; R₁₀, R₁₁) und wahlweisen Ausgabe des für den momentanen Pegelbereich des Eingangssignals (Vi) gewählten spannungsgeteilten Ausgangssignals des Spannungsteilers.

2. Vorrichtung zur nichtlinearen Verarbeitung nach Anspruch 1, wobei die Vorrichtung zur nichtlinearen Verarbeitung als ein Gamma-Kompensator verwendet wird.

3. Vorrichtung zur nichtlinearen Verarbeitung nach Anspruch 2, wobei jeder der Verstärker (AMP I, AMP II) mit einem Frequenzgangregler versehen ist (AMP, Z).

4. Vorrichtung zur nichtlinearen Verarbeitung nach Anspruch 2, wobei jeder der Verstärker (AMP I, AMP II) mit einem Offsetspannungsregler (AMP, VR) versehen ist.

5. Vorrichtung zur nichtlinearen Verarbeitung nach Anspruch 4, wobei eine einem minimalen Wert eines Eingangssignalpegels entsprechende Offsetspannung auf Null gesetzt ist.

6. Verfahren zur nichtlinearen Verarbeitung mit folgenden Schritten:
voneinander unabhängiges Erzeugen einer Vielzahl von Ausgangssignalen mit unterschiedlichen Offsetspannungen von Verstärkern mit in Bezug auf ein gemeinsames Eingangssignal unterschiedlichen Verstärkungsfaktoren;
voneinander unabhängiges Spannungsteilen jedes der Vielzahl von Ausgangssignalen durch mindestens zwei unabhängige Spannungsteiler, die mit dem Ausgangsanschluß jedes Verstärkers verbunden sind, um eine Vielzahl von unterschiedlichen spannungsgeteilten Signalen zu erzeugen, von denen jedes vorbestimmt ist, für einen bestimmten Pegelbereich des Eingangssignals gewählt zu werden; und
voneinander unabhängiges Empfangen der spannungsgeteilten Ausgangssignale der Spannungsteiler und wahlweises Ausgeben des für die momentane Größenordnung des Eingangssignals gewählten Ausgangssignals jedes Spannungsteilers.

## Revendications

1. Appareil de traitement non linéaire comprenant :
plusieurs amplificateurs (AMP I, AMP II) ayant des facteurs d'amplification mutuellement différents et différentes tensions de décalage (OFF I, OFF II) et raccordé de façon à avoir des bornes d'entrée alimentées par un signal d'entrée commun (Vi);
au moins deux diviseurs de tensions indépendants (R₁, R₂; R₄, R₅; R₇, R₈; R₁₀; R₁₁) raccordés à la borne de sortie de chaque amplificateur et ayant différentes sorties divisées en tension, chaque diviseur de tension étant prédéterminé pour, avoir son signal de sortie sélectionné pour une certaine région du niveau du signal d'entrée; et
un circuit mélangeur non additif (NAM) pour recevoir séparément les sorties divisées en tension des diviseurs de tension (R₁, R₂; R₄, R₅; R₇, R₈; R₁₀, R₁₁) et délivrer sélectivement la sortie divisée en tension du diviseur de tension sélectionné pour la région du niveau actuel du signal d'entrée (Vi).

2. Appareil de traitement non linéaire selon la revendication 1, dans lequel l'appareil de traitement non linéaire est utilisé comme compensateur gamma.

3. Appareil de traitement non linéaire selon la revendication 2, dans lequel chacun des amplificateurs (AMP I; AMP II) est équipé d'un régulateur de réponse en fréquence (AMP, Z).

4. Appareil de traitement non linéaire selon la revendication 2, dans lequel chacun des amplificateurs (AMP I; AMP II) est équipé d'un régulateur de tension de décalage (AMP, VR).

5. Appareil de traitement non linéaire selon la revendication 4, dans lequel une tension de décalage correspondant à une valeur minimale d'un niveau de signal d'entrée est mise à zéro.

6. Procédé de traitement non linéaire comprenant les étapes suivantes :
générer séparément une pluralité de signaux de sortie ayant différentes tensions de décalage à partir d'amplificateurs ayant différents facteurs d'amplification par rapport à un signal d'entrée commun;
diviser indépendamment en tension chacun de la pluralité des signaux de sortie par au moins deux diviseurs de tension indépendants raccordés à la borne de sortie de chaque amplificateur pour fournir une pluralité de signaux différents divisés en tension, chacun d'eux étant prédéfini pour être sélectionné pour une certaine région du niveau du signal d'entrée; et
recevoir séparément les sorties divisées en tension des diviseurs de tension, et délivrer sélectivement la sortie divisée en tension de chacun des diviseurs de tension sélectionnés pour la région du niveau actuel du signal d'entrée.
